# EUROPEAN PATENT APPLICATION

(11) **EP 4 672 890 A1**
(43) Date of publication of application: **31.12.2025**
(21) Application number: 25185087.1
(22) Date of filing: 25.06.2025
(51) Int. Cl.: H05K 7/20

(54) **THERMAL WALL HEAT REJECTION SYSTEM**

(30) Priority: 26.06.2024 US 202463664392 P; 10.06.2025 US 202519233679
(71) Applicant: Vertiv Corporation, Westerville, OH 43082 (US)
(72) Inventor: UCUBAGABRIEL, Medin Andeberhan, Lancaster (US); COLE, Andrew Nathan, Belbrook (US)
(74) Representative: Beal, James Michael

(57) **Abstract**

A thermal wall heat rejection system may include a first heat rejection unit including at least a first set of one or more first fans and a first coil. The system may further include a second heat rejection unit arranged proximate to the first heat rejection unit. The second heat rejection unit may further include a second set of one or more second fans and a second coil. The one or more first fans of the first heat rejection unit may face the one or more second fans of the second heat rejection unit to define a hot outlet aisle. The first coil of the first heat rejection unit may face the second coil of the second heat rejection unit to define a cold inlet aisle.

## Description

### CROSS-REFERENCE TO RELATED APPLICATIONS

The present application claims the benefit of U.S. Provisional Application No. 63/664,392, filed June 26, 2024, and of US Non-Provisional Application No. 19/233,679, filed June 10, 2025.

### TECHNICAL FIELD

The present disclosure generally relates to the field of cooling systems, and more particularly, to a thermal wall heat rejection system for high efficiency cooling systems.

### BACKGROUND

Cooling systems used for data centers typically include climate control systems to maintain the proper temperature and humidity in the data center. The climate control systems often include one or more computer room air conditioners (CRACs) coupled to heat rejection devices to provide cooled liquid to the CRACs. Heat rejection devices often transfer heat from the return fluid of the CRACs to a cooler medium.

Businesses today have accelerated their deployments of artificial intelligence (Al) and high compute applications. This shift towards Al results in higher density heat loads that will need to be cooled. However, current cooling solutions are limited by the existing data center designs and footprints which limit liquid cooling deployment. As such, there is a need for a thermal wall heat rejection system to provide high density heat rejection which cures the shortfalls of the previous approaches.

### SUMMARY

A thermal wall heat rejection system is disclosed, in accordance with one or more embodiments of the present disclosure. In embodiments, the thermal wall heat rejection system includes: a first heat rejection unit including at least a first set of one or more first fans and a first coil and a second heat rejection unit arranged proximate to the first heat rejection unit, where the second heat rejection unit includes a second set of one or more second fans and a second coil, where the one or more first fans of the first heat rejection unit face the one or more second fans of the second heat rejection unit to define a hot outlet aisle, and where the first coil of the first heat rejection unit faces the second coil of the second heat rejection unit to define a cold inlet aisle.

A thermal wall heat rejection unit is disclosed, in accordance with one or more embodiments of the present disclosure. In embodiments, the thermal wall heat rejection unit includes: a first set of heat rejection units and a second set of heat rejection units, where the first set of heat rejection units are configured to be stacked at least one of vertically or horizontally on the second set of heat rejection units, where each set of the first set of heat rejection units and the second set of heat rejection units includes: a first heat rejection unit including at least a first set of one or more first fans and a first coil; and a second heat rejection unit arranged proximate to the first heat rejection unit, where the second heat rejection unit includes a second set of one or more second fans and a second coil, where the one or more first fans of the first heat rejection unit face the one or more second fans of the second heat rejection unit to define a hot outlet aisle, and where the first coil of the first heat rejection unit faces the second coil of the second heat rejection unit to define a cold inlet aisle.

A cooling system is disclosed, in accordance with one or more embodiments of the present disclosure. In embodiments, the cooling system includes: one or more computer room air conditioning (CRAC) units; one or more refrigerant units configured to provide a refrigerant to the one or more CRAC units; and a thermal wall heat rejection sub-system, where the thermal wall heat rejection sub-system is configured to provide cooled refrigerant to the one or more CRAC units, where the thermal wall heat rejection sub-system includes: a first heat rejection unit including at least a first set of one or more first fans and a first coil; and a second heat rejection unit arranged proximate to the first heat rejection unit, where the second heat rejection unit includes a second set of one or more second fans and a second coil, where the one or more first fans of the first heat rejection unit face the one or more second fans of the second heat rejection unit to define a hot outlet aisle, and where the first coil of the first heat rejection unit faces the second coil of the second heat rejection unit to define a cold inlet aisle.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A is a simplified schematic view of a thermal wall heat rejection unit, in accordance with one or more embodiments of present disclosure.
FIG. 1B is a simplified schematic view of a thermal wall heat rejection unit, in accordance with one or more embodiments of present disclosure.
FIG. 2 is a simplified schematic view of a thermal wall heat rejection unit, in accordance with one or more embodiments of present disclosure.
FIG. 3A is a simplified top view of a thermal wall heat rejection system, in accordance with one or more embodiments of the present disclosure.
FIG. 3B is a simplified perspective view of a thermal wall heat rejection system, in accordance with one or more embodiments of the present disclosure.
FIG. 3C is a simplified side view of a thermal wall heat rejection system, in accordance with one or more embodiments of the present disclosure.
FIG. 3D is a simplified perspective view of a thermal wall heat rejection system, in accordance with one or more embodiments of the present disclosure.
FIG. 3E is a simplified schematic view of a thermal wall heat rejection system, in accordance with one or more embodiments of the present disclosure.
FIG. 3F is a simplified perspective view of a thermal wall heat rejection system, in accordance with one or more embodiments of the present disclosure.
FIGS. 4A and 4B are graphical representations comparing a footprint of a conventional system and the thermal wall heat rejection system, respectively.
FIG. 5 is a simplified block diagram of a cooling system including the thermal wall heat rejection system, in accordance with one or more embodiments of the present disclosure.

### DETAILED DESCRIPTION

Reference will now be made in detail to the subject matter disclosed, which is illustrated in the accompanying drawings.

Embodiments of the present disclosure are directed to a thermal wall heat rejection system. More particularly embodiments of the present disclosure are directed to a thermal wall heat rejection system that provides high heat rejection densities at rooftops (or data center halls). For example, the thermal wall heat rejection system may have horizontal air flow. In this regard, the heat rejection units of the thermal wall heat rejection system may be arranged vertically (or stacked) to create aisles of air inlets and fans. As such, the thermal wall heat rejection system may provide high density cooling solutions and retain sufficient seasonal coefficient of performance (SCOP). Further, the thermal wall heat rejection system may reduce the weight per unit and reduce recirculation.

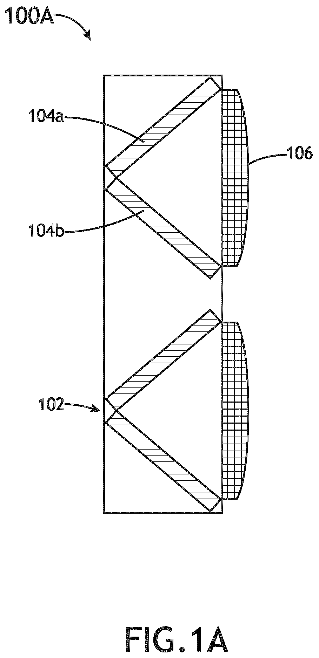

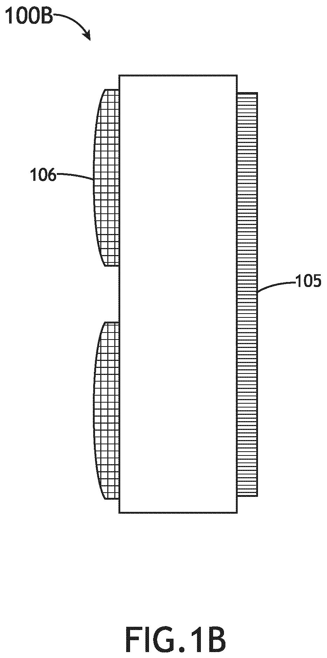

FIGS. 1A and 1B illustrate simplified schematics of thermal wall heat rejection units 100A, 100B, respectively, in accordance with one or more embodiments of the present disclosure.

The heat rejection units 100A, 100B may provide horizontal air flow.

The heat rejection units 100A, 100B may include one or more coils. For example, as shown in FIG. 1A, the heat rejection units 100A may include one or more sets of v-coil sets 102 (e.g., a plurality of v-coil sets). For instance, a first coil 104a and a second coil 104b of the v-coil set 102 may be arranged within the heat rejection units 100A in a "v-shape" configuration. By way of another example, as shown in FIG. 1B, the heat rejection units 100B may include one or more slab coils 105. For instance, the slab coil 105 may be arranged vertically along an edge (or side) of the heat rejection unit 100B.

Referring generally to FIGS. 1A and 1B, the heat rejection units 100A, 100B may include one or more fans 106. For example, the heat rejection units 100A, 100B may be arranged proximate to the one or more coils 102, 105. For instance, the heat rejection units 100A, 100B may be arranged on an edge (or side) of the heat rejection units 100A, 100B, opposite the one or more coils 102, 105. In a non-limiting example, as shown in FIG. 1A, the v-coil set 102 may be arranged such that the "v-shape" faces the one or more fans 106, where a point of convergence between the respective coils 104a, 104b may be on the opposite side of the one or more fans 106.

Although FIGS. 1A and 1B depict a specific number and configuration of coils 102, 105 and fans 106, it is contemplated herein that the thermal wall heat rejection unit 100A, 100B may include any number and configuration of coils 102, 105 (e.g., a plurality of coils, a single coil, or the like) and/or fans 106 suitable for meeting the cooling needs of the data center.

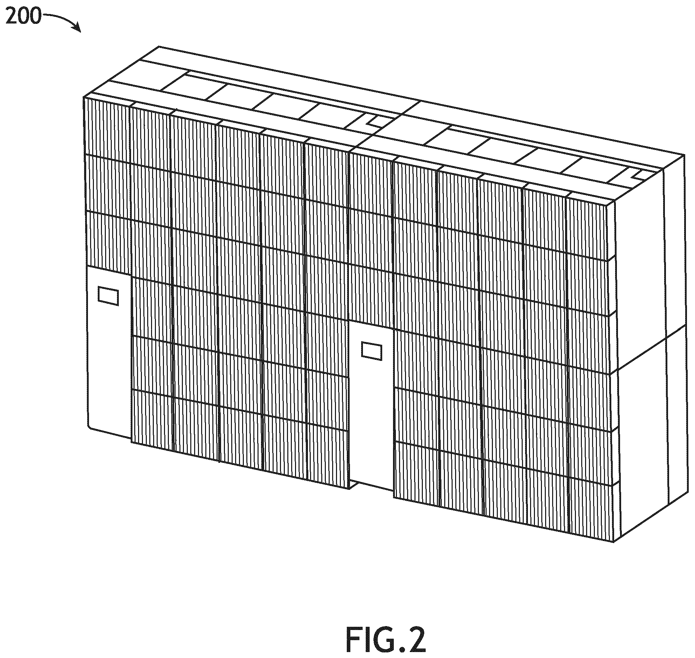

FIG. 2 illustrates a simplified schematic of one or more thermal wall heat rejection units 200, in accordance with one or more embodiments of the present disclosure. In some instances, the one or more heat rejection units 200 are similar to a traditional thermal wall cooling unit. For example, the one or more heat rejection units 200 may be designed for rooftops without the use of filters.

It is contemplated herein that thermal wall heat rejection units 100A, 100B, 200 may be utilized with a two-phase or single-phase system. Further, it is contemplated herein that thermal wall heat rejection units 100A, 100B, 200 may be used with any fluids suitable for operation in any orientation and for all air HX types.

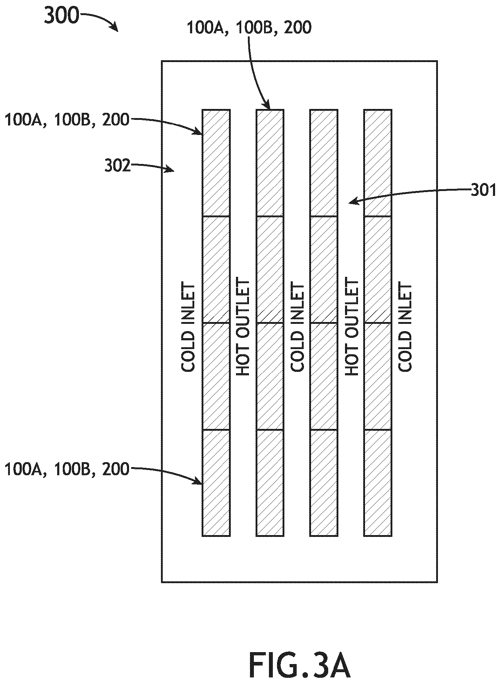

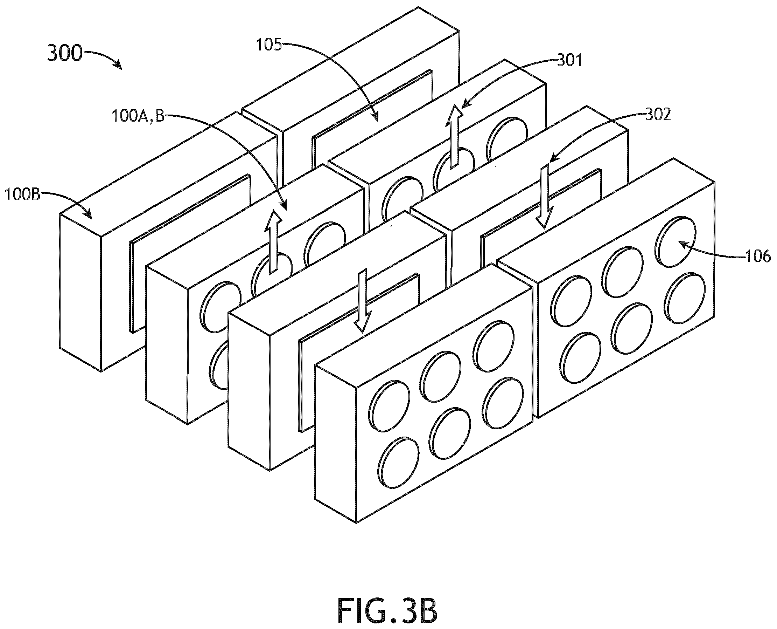

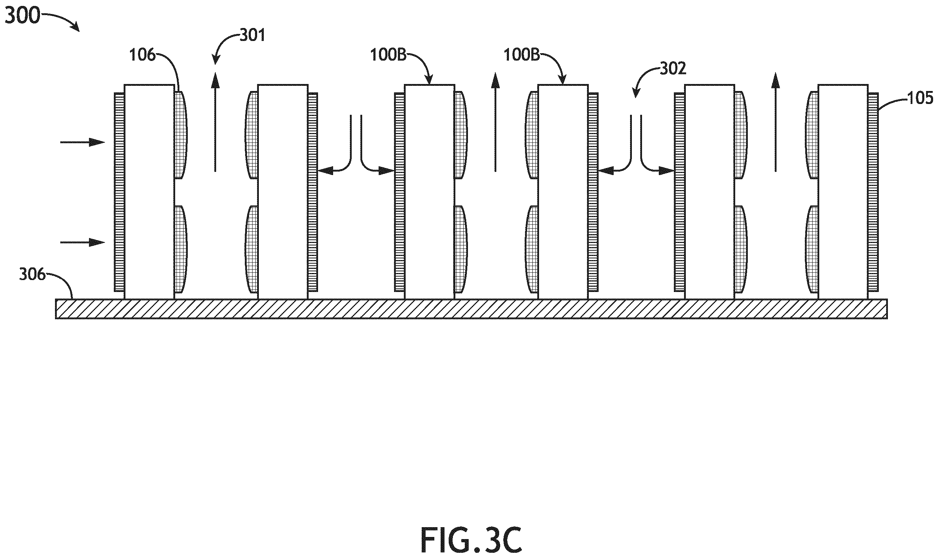

FIGS. 3A, 3B, and 3C illustrate simplified schematics of a heat rejection system 300 including a plurality of the thermal wall heat rejection units 100A, 100B, 200, in accordance with one or more embodiments of the present disclosure.

The heat rejection units 100A, 100B, 200 may be arranged in the system 300 to form one or more hot aisles 301 and one or more cold aisles 302. For example, as shown in FIG. 3A, the thermal heat rejection system 300 may include heat rejection units 100A, 100B, 200 arranged to form a cold inlet aisle 302 and heat rejection units 100A, 100B, 200 to form a hot outlet aisle 301, where the respective aisles are interweaved between each other. For instance, continuing with the above non-limiting example, the system 300 may include a first set of heat rejection units 100A, 100B, 200, a second set of heat rejection units 100A, 100B, 200, a third set of heat rejection units 100A, 100B, 200, and a fourth set of heat rejection units 100A, 100B, 200, where the first set of heat rejection units is arranged adjacent the second set of heat rejection units to form a first cold inlet and hot outlet, and so on.

Referring to FIGS. 3B and 3C, the heat rejection units 100A, 100B may be arranged vertically. For example, the respective thermal wall units 100A, 100B may be arranged such that the fans 106 of the heat rejection units 100A, 100B are facing each to form the hot outlet aisles 301. In this regard, aisles of fans 106 may be formed to make up the respective hot outlet aisles 301. By way of another example, the respective thermal wall units 100A, 100B may be arranged such that the coils 102, 105 of the heat rejection units 100A, 100B are facing each other to form the cold inlet aisles 302. In this regard, aisles of inlets may be formed to make up the respective cold inlet aisles 302.

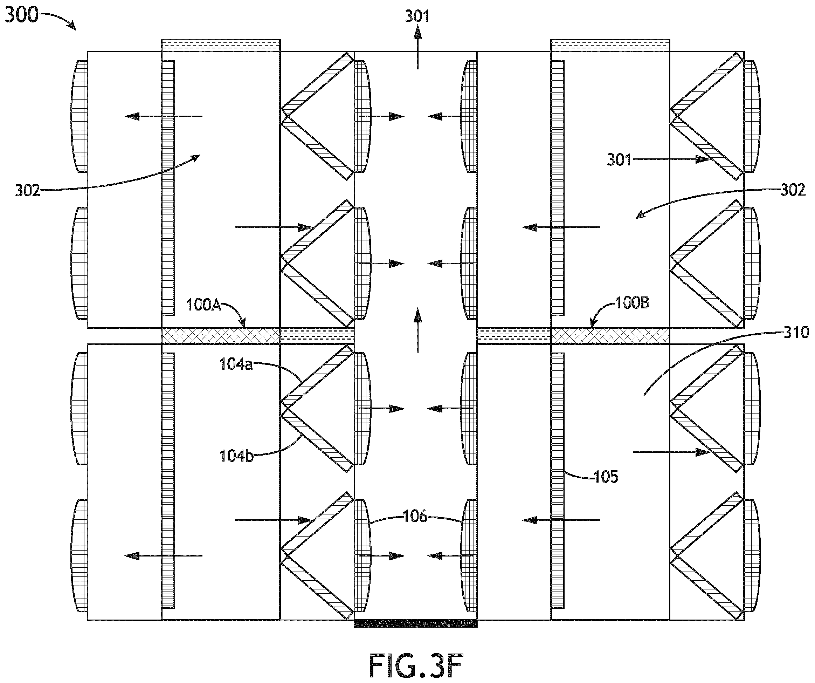

Referring to FIGS. 2 and 3F, the heat rejection units may be stacked. For example, as shown in FIG. 2, the heat rejection units 200 may be stacked vertically. By way of another example, as shown in FIG. 3F, the heat rejection units 100A, 100B may be stacked vertically. It is further contemplated herein, the heat rejection units 100A, 100B, 200 may be stacked horizontally.

Referring to FIG. 3C, the heat rejection units 100B may be installed (or disposed) on top of a roof top 306. Although FIG. 3C depicts the system 300 including the heat rejection units 100B being installed on the roof top 306, it is contemplated herein that the heat rejection units 100A, 200 may further be installed on the roof top 306, unless otherwise provided herein.

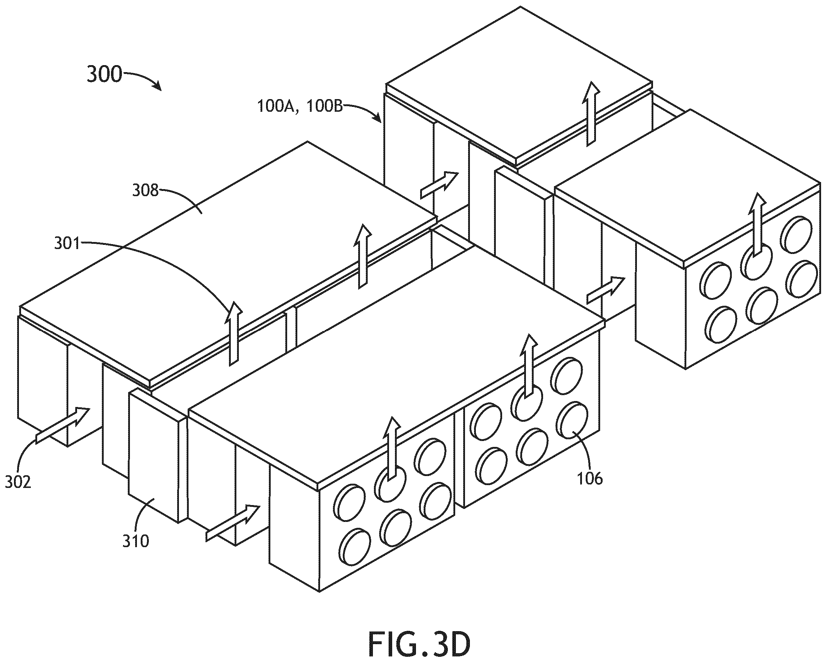

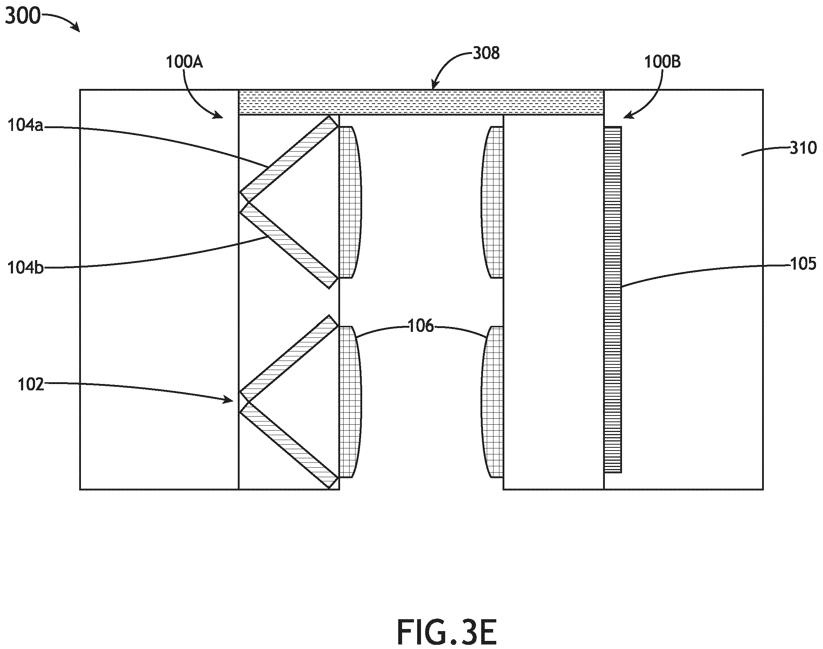

Referring to FIGS. 3D, 3E, and 3F, the heat rejection units 100A ,100B may include one or more covers (or walls). For example, the heat rejection units 100A, 100B may be coupled to a top cover 308. For instance, at least a top surface of the heat rejection units 100A, 100B may be configured to couple to the top cover 308. By way of another example, the heat rejection units 100A, 100B may be coupled to one or more side covers 310. For instance, as shown in FIG. 3F, the one or more side covers 310 may be added to the ends of the hot aisles 301 to direct the hot rejection air away from the cold aisle inlets.

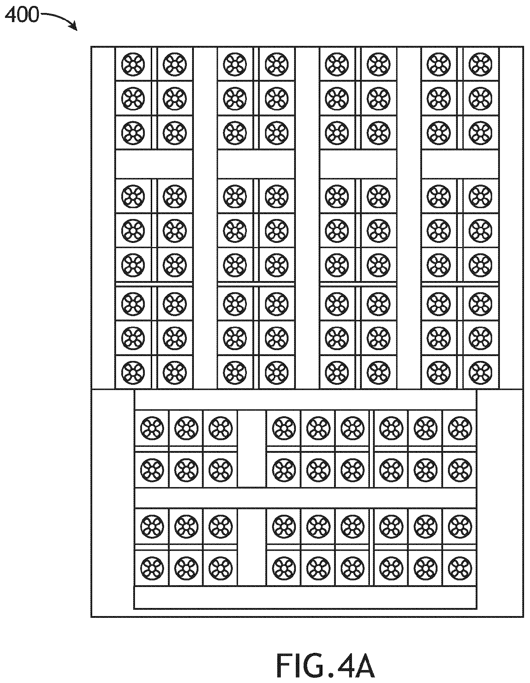

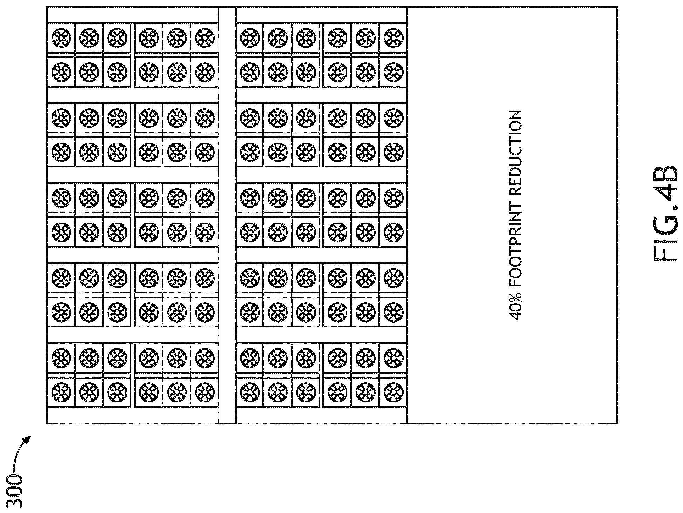

It is contemplated herein that the thermal heat rejection system 300 may reduce the footprint by approximately 40% compared to traditional flat coil systems, as shown in FIGS. 4A and 4B. For example, FIG. 4A depicts a conventional system 400 and FIG. 4B depicts the thermal heat rejection system 300 as disclosed herein. As shown in FIG. 4B, the thermal heat rejection system 300 may utilize much less space, thereby reducing the footprint by, e.g., approximately 40%. In this regard, the thermal wall heat rejection system 300 may be suitable for existing data center designs (and roof tops) and future data center designs.

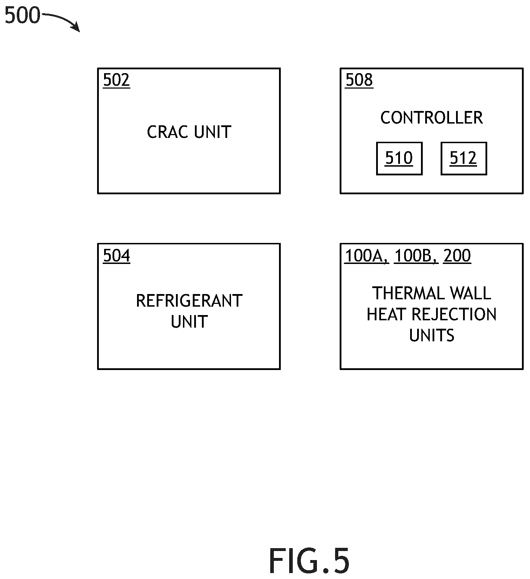

FIG. 5 illustrates a simplified block diagram of a cooling system 500 including one or more of the thermal heat rejection units 100A, 100B, 200, in accordance with one or more embodiments of the present disclosure.

The cooling system 500 may include one or more computer room air conditioner (CRAC) units 502. For example, the one or more CRAC units 502 may be coupled to one or more of the heat rejection units 100A, 100B, 200 to provide cooled liquid to the one or more CRAC units 502. Further, the heat rejection units 100A, 100B, 200 may transfer heat from a return fluid from the one or more CRAC units 502 to a cooler medium, such as outside ambient air.

It is contemplated herein that the one or more CRAC units 502 may use any type of cooling technology. For example, the one or more CRAC units 502 may include one or more air cooled heat exchanges. By way of another example, the one or more CRAC units 502 may include one or more liquid cooled heat exchangers.

In some instances, the heat rejection units 100A, 100B, 200 of the cooling system 500 may be coupled together via one or more fastening members to provide additional support. In this regard, the heat rejection units 100A, 100B, 200 may be strapped together to provide additional support and protection from environmental factors (e.g., wind, earthquakes, tornados, or the like).

The cooling system 500 may include one or more refrigerant units 504. For example, the one or more refrigerant units 504 may provide liquid refrigerant to the one or more CRAC units 502. In some instances, the one or more CRAC units 502 may be phase change refrigerant air conditioning systems having refrigerant compressors, such as a direct exchange (DX) system.

The cooling system 500 may further include one or more controllers 508 including one or more processors 510 and memory 512. The one or more controllers 508 may be configured to adjust one or more settings of the one or more components of the cooling system 500 based on one or more factors (e.g., outdoor temperature). For example, the one or more controllers 508 may be configured to receive an outdoor temperature reading for an outdoor temperature sensor (e.g., part of the cooling system or external to the cooling system) and adjust one or more settings based on the received outdoor temperature reading. For instance, the one or more controllers 508 may be configured to generate one or more control signals configured to adjust one or more settings of at least one of the one or more CRAC units, the one or more refrigerant units, or the thermal wall heat rejection sub-system based on the outdoor temperature reading.

It is noted herein that the one or more components of system may be communicatively coupled to the various other components of system in any manner known in the art. For example, the one or more processors may be communicatively coupled to each other and other components via a wireline (e.g., copper wire, fiber optic cable, and the like) or wireless connection (e.g., RF coupling, IR coupling, WiMax, Bluetooth, 3G, 4G, 4G LTE, 5G, and the like). By way of another example, the controller may be communicatively coupled to one or more components of system via any wireline or wireless connection known in the art.

The one or more processors may include any one or more processing elements known in the art. In this sense, the one or more processors may include any microprocessor device configured to execute algorithms and/or program instructions. In general, the term "processor" may be broadly defined to encompass any device having one or more processing elements, which execute a set of program instructions from a non-transitory memory medium (e.g., the memory), where the one or more sets of program instructions are configured to cause the one or more processors to carry out any of one or more process steps.

The memory may include any storage medium known in the art suitable for storing the one or more sets of program instructions executable by the associated one or more processors. For example, the memory may include a non-transitory memory medium. For instance, the memory may include, but is not limited to, a read-only memory (ROM), a random access memory (RAM), a magnetic or optical memory device (e.g., disk), a magnetic tape, a solid state drive, and the like. The memory may be configured to provide display information to the user device. In addition, the memory may be configured to store user input information from one or more user input devices. The memory may be housed in a common controller housing with the one or more processors. The memory may, alternatively or in addition, be located remotely with respect to the spatial location of the processors and/or the one or more controllers. For instance, the one or more processors, the one or more controllers may access a remote database, accessible through a network (e.g., internet, intranet, and the like) via one or more communication interfaces.

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.

The disclosure comprises the following items:
1. A thermal wall heat rejection system comprising:
   a first heat rejection unit including at least a first set of one or more first fans and a first coil; and
   a second heat rejection unit arranged proximate to the first heat rejection unit,
   wherein the second heat rejection unit includes a second set of one or more second fans and a second coil,
   wherein the one or more first fans of the first heat rejection unit face the one or more second fans of the second heat rejection unit to define a hot outlet aisle, and
   wherein the first coil of the first heat rejection unit faces the second coil of the second heat rejection unit to define a cold inlet aisle.
2. The thermal wall heat rejection system of item 1, wherein the first heat rejection unit and the second heat rejection unit are disposed on a roof top.
3. The thermal wall heat rejection system of item 1 or item 2, wherein at least one of the first coil or the second coil includes a plurality of coils.
4. The thermal wall heat rejection system of any preceding item, wherein the plurality of coils includes one or more sets of v-coils.
5. The thermal wall heat rejection system of any preceding item, wherein the plurality of coils includes a plurality of slab coils.
6. The thermal wall heat rejection system of any preceding item, wherein at least one of the first coil or the second coil includes a single coil slab.
7. The thermal wall heat rejection system of any preceding item, further comprising:
   one or more covers configured to couple to one or more surfaces of at least one of the first heat rejection unit or the second heat rejection unit.
8. The thermal wall heat rejection system of any preceding item, wherein the one or more covers include one or more top covers, wherein the one or more top covers are configured to couple to at least a top surface of the first heat rejection unit and at least an additional top surface of the second heat rejection unit.
9. The thermal wall heat rejection system of any preceding item, wherein the one or more covers include one or more side covers, wherein the one or more side covers are configured to couple to at least a side surface of the first heat rejection unit and at least an additional side surface of the second heat rejection unit.
10. A thermal wall heat rejection unit comprising:
   a first set of heat rejection units; and
   a second set of heat rejection units, wherein the first set of heat rejection units are configured to be stacked at least one of vertically or horizontally on the second set of heat rejection units,
   wherein each set of the first set of heat rejection units and the second set of heat rejection units comprises:
      a first heat rejection unit including at least a first set of one or more first fans and a first coil; and
      a second heat rejection unit arranged proximate to the first heat rejection unit,
      wherein the second heat rejection unit includes a second set of one or more second fans and a second coil,
      wherein the one or more first fans of the first heat rejection unit face the one or more second fans of the second heat rejection unit to define a hot outlet aisle, and
      wherein the first coil of the first heat rejection unit faces the second coil of the second heat rejection unit to define a cold inlet aisle.
11. The thermal wall heat rejection unit of item 10, wherein the first set of heat rejection units and the second set of heat rejection units are disposed on a roof top.
12. The thermal wall heat rejection unit of item 10 or item 11, wherein at least one of the first coil or the second coil includes a plurality of coils.
13. The thermal wall heat rejection unit of any of items 10-12, wherein the plurality of coils includes one or more sets of v-coils.
14. The thermal wall heat rejection unit of any of items 10-13, wherein the plurality of coils includes a plurality of slab coils.
15. The thermal wall heat rejection unit of any of items 10-14, wherein at least one of the first coil or the second coil includes a single coil slab.
16. The thermal wall heat rejection unit of any of items 10-15, further comprising:
   one or more covers configured to couple to one or more surfaces of at least one of the first set of heat rejection units or the second set of heat rejection units.
17. The thermal wall heat rejection unit of any of items 10-16, wherein the one or more covers include one or more top covers, wherein the one or more top covers are configured to couple to at least a top surface of the first heat rejection unit and at least an additional top surface of the second heat rejection unit.
18. The thermal wall heat rejection unit of any of items 10-17, wherein the one or more covers include one or more side covers, wherein the one or more side covers are configured to couple to at least a side surface of the first set of heat rejection units and at least an additional side surface of the second set of heat rejection units.
19. A cooling system comprising:
   one or more computer room air conditioning (CRAC) units;
   one or more refrigerant units configured to provide a refrigerant to the one or more CRAC units; and
   a thermal wall heat rejection sub-system, wherein the thermal wall heat rejection sub-system is configured to provide cooled refrigerant to the one or more CRAC units, wherein the thermal wall heat rejection sub-system comprises:
      a first heat rejection unit including at least a first set of one or more first fans and a first coil; and
      a second heat rejection unit arranged proximate to the first heat rejection unit,
      wherein the second heat rejection unit includes a second set of one or more second fans and a second coil,
      wherein the one or more first fans of the first heat rejection unit face the one or more second fans of the second heat rejection unit to define a hot outlet aisle, and
      wherein the first coil of the first heat rejection unit faces the second coil of the second heat rejection unit to define a cold inlet aisle.
20. The cooling system of item 19, further comprising:
   one or more controllers including one or more processors configured to execute a set of program instructions, wherein the set of program instructions are configured to cause the one or more processors to:
   generating one or more control signals configured to adjust one or more settings of at least one of the one or more CRAC units, the one or more refrigerant units, or the thermal wall heat rejection sub-system based on an outdoor temperature.

## Claims

1. A thermal wall heat rejection system comprising:
a first heat rejection unit including at least a first set of one or more first fans and a first coil; and
a second heat rejection unit arranged proximate to the first heat rejection unit,
wherein the second heat rejection unit includes a second set of one or more second fans and a second coil,
wherein the one or more first fans of the first heat rejection unit face the one or more second fans of the second heat rejection unit to define a hot outlet aisle, and
wherein the first coil of the first heat rejection unit faces the second coil of the second heat rejection unit to define a cold inlet aisle.

2. The thermal wall heat rejection system of claim 1, wherein the first heat rejection unit and the second heat rejection unit are disposed on a roof top.

3. The thermal wall heat rejection system of claim 1 or claim 2, wherein at least one of the first coil or the second coil includes a plurality of coils.

4. The thermal wall heat rejection system of claim 3, wherein the plurality of coils includes one or more sets of v-coils.

5. The thermal wall heat rejection system of claim 3 or claim 4, wherein the plurality of coils includes a plurality of slab coils.

6. The thermal wall heat rejection system of any preceding claim, wherein at least one of the first coil or the second coil includes a single coil slab.

7. The thermal wall heat rejection system of any preceding claim, further comprising:
one or more covers configured to couple to one or more surfaces of at least one of the first heat rejection unit or the second heat rejection unit.

8. The thermal wall heat rejection system of claim 7, wherein the one or more covers include one or more top covers, wherein the one or more top covers are configured to couple to at least a top surface of the first heat rejection unit and at least an additional top surface of the second heat rejection unit.

9. The thermal wall heat rejection system of claim 7 or claim 8, wherein the one or more covers include one or more side covers, wherein the one or more side covers are configured to couple to at least a side surface of the first heat rejection unit and at least an additional side surface of the second heat rejection unit.

10. A thermal wall heat rejection unit comprising:
a first set of heat rejection units; and
a second set of heat rejection units, wherein the first set of heat rejection units are configured to be stacked at least one of vertically or horizontally on the second set of heat rejection units,
wherein each set of the first set of heat rejection units and the second set of heat rejection units comprises a respective instance of the thermal wall heat rejection system of any preceding claim.

11. A cooling system comprising:
one or more computer room air conditioning, CRAC, units;
one or more refrigerant units configured to provide a refrigerant to the one or more CRAC units; and
a thermal wall heat rejection sub-system, wherein the thermal wall heat rejection sub-system is configured to provide cooled refrigerant to the one or more CRAC units, wherein the thermal wall heat rejection sub-system comprises the features of the thermal wall heat rejection system of any of claims 1-9.

12. The cooling system of claim 11, further comprising:
one or more controllers including one or more processors configured to execute a set of program instructions, wherein the set of program instructions are configured to cause the one or more processors to:
generate one or more control signals configured to adjust one or more settings of at least one of the one or more CRAC units, the one or more refrigerant units, or the thermal wall heat rejection sub-system based on an outdoor temperature.
